# FASCICULE DE BREVET EUROPEEN

(11) **EP 1 209 808 B1**
(45) Date de publication et mention de la délivrance du brevet: **09.05.2007**
(21) Numéro de dépôt: 01430033.9
(22) Date de dépôt: 12.11.2001
(51) Int. Cl.: H03K 3/84, G06F 7/58

(54) **Générateur de signal aléatoire**
Zufallssignalgenerator
Random signal generator

(30) Priorité: 28.11.2000 FR 0015309
(43) Date de publication de la demande: 29.05.2002
(73) Titulaire: STMicroelectronics SA, F-92120 Montrouge (FR)
(72) Inventeur: Marinet, Fabrice, 13790 Chateauneuf le Rouge (FR); Malherbe, Alexandre, 13530 Trets (FR)
(74) Mandataire: Marchand, André

(56) Documents cités:
- PATENT ABSTRACTS OF JAPAN vol. 007, no. 076 (E-167), 30 mars 1983 (1983-03-30) & JP 58 005006 A (NIPPON DENKI KK), 12 janvier 1983 (1983-01-12)
- RODRIGUEZ-VAZQUEZ A ET AL: "CMOS DESIGN OF CHAOTIC OSCILLATORS USING STATE VARIABLES: A MONOLITHIC CHUA'S CIRCUIT" IEEE TRANSACTIONS ON CIRCUITS AND SYSTEMS II: ANALOG AND DIGITAL SIGNAL PROCESSING, IEEE INC. NEW YORK, US, vol. 40, no. 10, 1 octobre 1993 (1993-10-01), pages 596-613, XP000421292 ISSN: 1057-7130

## Description

La présente invention concerne un procédé et un dispositif pour la génération d'un signal aléatoire.

La présente invention s'applique notamment, mais non exclusivement, à la réalisation d'un générateur de signal binaire aléatoire pour carte à puce.

Un générateur de signal binaire aléatoire permet par exemple à une carte à puce, au cours d'une procédure d'authentification d'un terminal, d'envoyer au terminal une séquence binaire aléatoire comprenant par exemple 16 ou 32 bits. La carte et le terminal appliquent à cette séquence une fonction d'authentification à clé secrète. Le terminal transmet ensuite à la carte le résultat obtenu, et la carte compare le résultat qu'elle a calculé avec celui qu'elle a reçu du terminal. Si les deux résultats sont identiques, le terminal est présumé authentique et la carte accepte la transaction demandée.

On connaît dans l'art antérieur des générateurs d'aléas se présentant sous la forme d'une machine logique comportant un nombre fini d'états internes. Une telle machine logique comprend par exemple des registres à décalage dont certains bits sont renvoyés en entrée de la machine par l'intermédiaire d'une porte OU Exclusif. A partir d'un état interne initial, on active la machine logique au moyen d'un signal d'horloge et l'on extrait de la machine logique, à chaque coup d'horloge, un bit aléatoire.

Toutefois, l'inconvénient de telles machines logiques est qu'elles génèrent des séquences binaires déterministes qui présentent un taux élevé de répétitivité, ainsi qu'un biais statistique de sortie portant sur la répartition des "1" et des "0". Pour pallier cet inconvénient, il faut prévoir des machines logiques présentant un grand nombre d'états internes (l'idéal étant que la machine présente un nombre infini d'états internes), mais cette solution va à l'encontre des exigences de simplicité, de faible coût et de faible consommation des générateurs aléatoires.

Un générateur de signal aléatoire peut également être réalisé au moyen d'une source de bruit électronique, telle que le bruit d'une diode en avalanche ou d'une diode polarisée, ou encore le bruit thermique dans une résistance. Toutefois, ces sources de bruit sont de très faible amplitude, de sorte qu'il est nécessaire de prévoir un amplificateur à gain élevé, au minimum de 60 dB, impliquant l'utilisation de transistors bipolaires qui présentent une consommation importante. Or, la présence de tels transistors est exclue dans de nombreux circuits intégrés, notamment ceux destinés aux cartes à puce.

Le document JP 58 005006 décrit l'utilisation d'un transistor MOS à déplétion pour réaliser une source de bruit blanc.

Ainsi, un objectif de la présente invention est de prévoir un générateur de signal aléatoire qui ne présente pas les inconvénients des générateurs connus.

Pour atteindre cet objectif, la présente invention se fonde sur la constatation selon laquelle les transistors MOS coudés, présentant un canal en lacets, sont réputés inutilisables lorsque l'on se trouve à la limite de la technologie d'intégration employée, du fait que le courant drain-source dans de tels transistors présente une composante aléatoire de plus en plus importante au fur et à mesure que les dimensions du canal en lacets diminuent. Une idée de la présente invention est de tirer profit de cet inconvénient pour réaliser un générateur de signal aléatoire intégrable dans un circuit intégré, notamment un circuit intégré pour carte à puce.

Ainsi, la présente invention prévoit un générateur de signal aléatoire du type utilisant une source de bruit électronique, dans lequel la source de bruit électronique comprend un transistor MOS coudé comportant un canal en forme de S ou en lacets dont les dimensions sont à la limite de la résolution offerte par la technique de fabrication du transistor, le transistor présentant un courant drain-source ayant une composante aléatoire, le générateur comprenant des moyens pour produire un signal binaire aléatoire à partir de la composante aléatoire.

Selon un mode de réalisation, le générateur comprend un transistor de référence auquel sont appliqués une tension de grille et un courant de polarisation identiques à ceux appliqués au transistor coudé, pour extraire la composante aléatoire.

Selon un mode de réalisation, le générateur comprend des moyens pour comparer la composante aléatoire à un courant de détection.

Selon un mode de réalisation, le générateur comprend des moyens pour amplifier la composante aléatoire.

Selon un mode de réalisation, le générateur comprend des moyens pour échantillonner le signal binaire aléatoire, de manière à obtenir un signal numérique aléatoire.

Selon un mode de réalisation, le générateur comprend un circuit logique pour produire des nombres binaires aléatoires à partir du signal numérique aléatoire.

Selon un mode de réalisation, le générateur comprend des moyens pour maintenir automatiquement la tension de grille du transistor coudé dans une plage de valeurs déterminée assurant la délivrance d'un signal de sortie équiprobable.

Selon un mode de réalisation, le générateur comprend plusieurs sources de bruit électronique produisant un courant ayant une composante aléatoire, chaque source étant couplée respectivement à des moyens pour générer un signal binaire aléatoire à partir de la composante aléatoire produite par la source, le générateur comprenant en outre des moyens pour combiner les signaux binaires aléatoires issus des sources pour produire des nombres binaires aléatoires.

La présente invention concerne également un circuit intégré comprenant un générateur de signal binaire aléatoire selon l'invention, et des moyens pour relier la sortie du générateur à d'autres composants du circuit intégré.

Selon un mode de réalisation, le circuit intégré est agencé sur un support pour former une carte à puce ou tout autre objet électronique portable équivalent.

Selon un mode de réalisation, le circuit intégré comprend une unité de traitement comprenant des moyens pour recevoir un nombre aléatoire produit par le générateur, des moyens pour émettre ce nombre aléatoire à destination d'un terminal extérieur, des moyens pour appliquer à ce nombre aléatoire une fonction d'authentification à clé secrète, des moyens pour comparer le résultat de cette fonction à un résultat fourni par le terminal en réponse à l'émission du nombre aléatoire, et des moyens pour autoriser une transaction avec le terminal si le résultat fourni par le terminal correspond au résultat calculé par l'unité de traitement.

La présente invention concerne également un procédé pour générer un signal aléatoire à partir d'une source de bruit électronique, comprenant les étapes consistant à prévoir un transistor coudé présentant un canal en forme de S ou en lacets dont les dimensions sont choisies à la limite de la résolution offerte par la technique de fabrication du transistor, extraire une composante aléatoire de courant aux bornes d'un transistor MOS coudé, générer un signal binaire en fonction de la composante aléatoire, et échantillonner le signal binaire.

Selon un mode de réalisation, le procédé comprend des étapes consistant à amplifier la composante aléatoire et lui retrancher une valeur de référence avant de la convertir en un signal binaire.

Selon un mode de réalisation, le procédé comprend une étape d'ajustement de la tension de grille du transistor coudé en fonction du signal binaire aléatoire obtenu à la suite de l'étape d'échantillonnage.

Selon un mode de réalisation, le procédé comprend une étape consistant à générer des nombres binaires à partir du signal binaire.

Ces objets, caractéristiques et avantages ainsi que d'autres de la présente invention seront exposés plus en détail dans la description suivante d'un générateur selon l'invention, faite à titre non limitatif en relation avec les figures jointes parmi lesquelles :
- la figure 1 est le schéma électrique d'un générateur aléatoire selon l'invention,
- la figure 2 est une vue détaillée d'un composant de référence présent dans le générateur de la figure 1,
- la figure 3 est une vue détaillée d'un composant utilisé comme source de bruit dans le générateur de la figure 1,
- la figure 3a représente un détail du composant représenté en figure 3,
- la figure 4 représente des courbes de variation du courant dans le composant de référence et le composant source de bruit en fonction d'une tension appliquée à ces composants,
- la figure 5 représente des courbes de variation du courant en un autre point du générateur aléatoire, en fonction de la tension appliquée aux composants de référence et source de bruit,
- la figure 6 représente sous forme de blocs un exemple d'application d'un générateur de signal aléatoire selon l'invention, et
- la figure 7 représente un générateur aléatoire comprenant plusieurs générateurs selon l'invention.

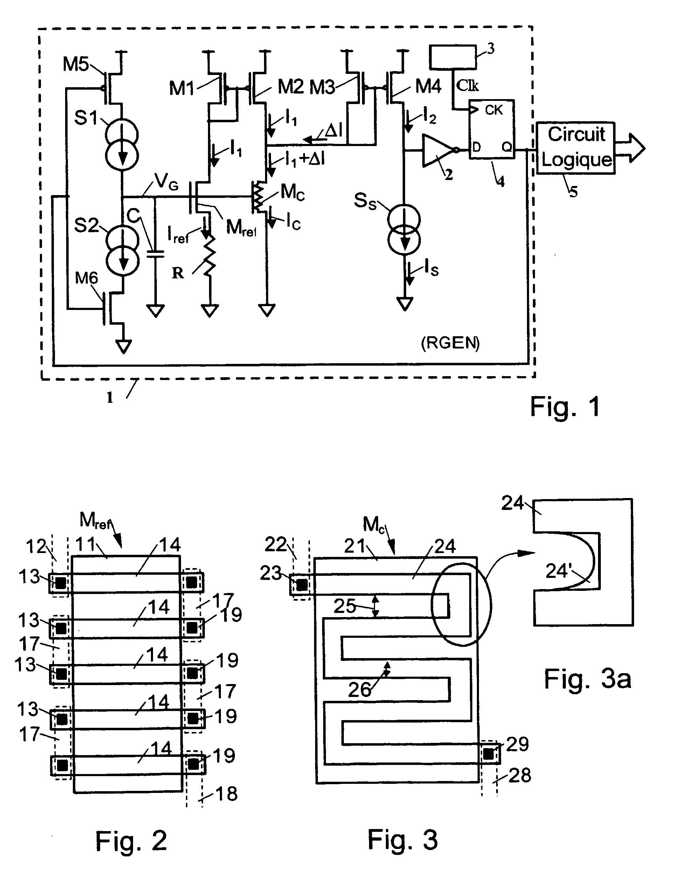

La figure 1 représente un générateur de signaux binaires aléatoires RGEN 1 selon l'invention. Le générateur comprend un transistor M_{C} utilisé comme source de bruit électronique, ainsi qu'un transistor de référence M_{ref}. Selon l'invention, le transistor M_{C} est de type MOS coudé présentant un courant drain-source qui varie d'une manière aléatoire dans une plage déterminée de valeurs, pour une tension de grille donnée. Le transistor de référence M_{ref} présente des caractéristiques analogues à celles du transistor M_{C}, mais sans composante aléatoire.

Le générateur 1 comprend deux transistors M1, M2 agencés en miroir de courant qui polarisent les deux transistors M_{ref} et M_{C} en appliquant sur leur drain un même courant I₁. La source du transistor M_{C} est connectée à la masse tandis que la source du transistor M_{ref} est reliée à la masse par l'intermédiaire d'une résistance R d'équilibrage de la résistance drain-source du transistor M_{C}. Du fait que le courant drain-source dans le transistor M_{C} présente une composante aléatoire, le courant au niveau du drain est égal à I₁+ΔI.

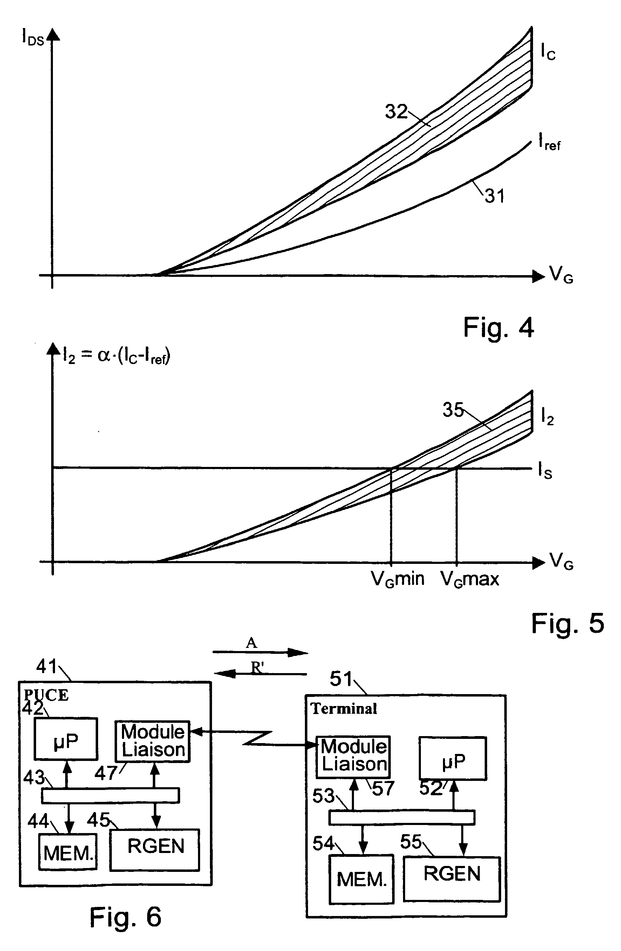

La figure 4 représente les courbes de variation 31, 32 en fonction de la tension de grille V_{G}, des courants drain-source I_{ref} et I_{C}, respectivement dans les transistors M_{ref} et M_{C}. Il apparaît que plus la tension V_{G} augmente, plus la composante aléatoire ΔI (largeur de la zone hachurée 32) du courant I_{C} augmente.

Le générateur 1 comprend en outre deux transistors M3, M4 également agencés en miroir de courant, la source et la grille du transistor M3 étant connectée au drain du transistor M_{C}. De cette manière, le transistor M3 mesure la différence de courant ΔI=I_{C}-I_{ref} entre les courants de drain des transistors M_{C} et M_{ref}, et le courant I₂ à la source du transistor M4 correspond au courant ΔI multiplié par un gain α, de sorte que I₂ = α·ΔI. Le transistor M4 est surdimensionné par rapport au transistor M3, de sorte que le rapport d'amplification ou gain α soit supérieur à 1, par exemple égal à 2.

La figure 5 représente la courbe de variation du courant I₂ en fonction de la tension de grille V_{G}. Comme le courant I_{C} comporte une composante aléatoire, le courant I₂ présente également une composante aléatoire représentée par la zone hachurée 35.

La source du transistor M4 est connectée à une source de courant S_{S} fournissant un courant de détection de référence I_{S} (représenté sur la figure 5), de manière à obtenir sur la source du transistor M4 un courant égal à I₂-I_{S}. Ce courant différentiel est appliqué à l'entrée d'une porte inverseuse 2 dont la sortie délivre un signal logique égal à 0 lorsque I₂ est supérieur à I_{S} et égal à 1 dans le cas contraire. Le signal logique est échantillonné au moyen d'une bascule 4 de type D dont l'entrée D est connectée à la sortie de la porte 2 et dont la sortie Q délivre le signal binaire aléatoire. L'entrée d'horloge CK de la bascule 4 est pilotée par un signal d'horloge Clk de fréquence déterminée, délivré par un oscillateur 3 interne ou externe au générateur.

Pour que le courant I₂ oscille d'une manière aléatoire autour du courant I_{S}, le signal sur la sortie Q de la bascule 4 est renvoyé sur la grille des transistors M_{ref} et M_{C} par l'intermédiaire d'un circuit intégrateur permettant d'ajuster automatiquement la tension de grille V_{G}. De ce fait, la tension de grille V_{G} se trouve comprise dans une zone délimitée par des valeurs V_{G}min et V_{G}max représentées en figure 5, correspondant à la largeur de la zone hachurée 35.

Le circuit intégrateur comprend ici un transistor PMOS M5 et un transistor NMOS M6. La source du transistor M5 est reliée au drain du transistor M6 par l'intermédiaire de deux sources de courant S1, S2 en série. Le signal délivré par la sortie Q de la bascule 4 est appliqué sur les grilles des deux transistors M5 et M6 et le noeud de jonction des sources de courant S1, S2 est relié aux grilles des transistors M_{C} et M_{ref}. La grille des deux transistors M_{C} et M_{ref} est par ailleurs reliée à la masse par l'intermédiaire d'un condensateur C qui complète les capacités de grille relativement élevées des transistors M_{ref} et M_{C} pour intégrer la tension de grille V_{G} en se chargeant et en se déchargeant à courant constant.

Ainsi, lorsque le signal présent sur la sortie Q de la bascule 4 est à 0, le transistor M6 est bloqué et le transistor M5 est passant. La source de courant S1 applique alors un courant au noeud de connexion des grilles des transistors M_{ref}, M_{C} et de la capacité C.

Si au contraire le niveau logique du signal appliqué à l'entrée du circuit intégrateur est à 1, le transistor M5 est bloqué et le transistor M6 est passant. La source de courant S2 applique alors un courant au noeud de connexion des grilles des transistors M_{ref}, M_{C} et de la capacité C.

Ainsi, le dispositif intégrateur suit en permanence les variations de courant dans le transistor M_{C} de manière que la tension de grille V_{G} reste comprise entre V_{G}min et V_{G}max et que les bits à "1" ou à "0" à la sortie du générateur soient équiprobables.

Les figures 2 et 3 représentent plus en détail les transistors M_{ref} et M_{C}. Sur la figure 2, le transistor MOS M_{ref} comprend d'une manière classique plusieurs canaux 14 rectilignes et parallèles, formés par implantation de dopant dans un substrat semi-conducteur, l'ensemble de ces canaux étant recouvert par une grille 11 constituée d'une couche mince électriquement isolante, par exemple en polysilicium (silicium polycristallin), cette couche étant recouverte d'une métallisation constituant la connexion de grille. Les extrémités de chaque canal 14 sont munies de zones de contact 13, 19 et sont interconnectées en série par des métallisations 17 représentées en traits interrompus, deux zones de contact 13, 19 extrêmes de la chaîne ainsi réalisée, étant munis de métallisations; respectivement 12, 18, constituant les connexions de drain et de source du transistor. En d'autres termes, le transistor M_{ref} est constitué de plusieurs transistors montés en série avec une grille commune.

Sur la figure 3, le transistor M_{C} comprend un canal 24 également formé par implantation de dopant dans un substrat semi-conducteur, ce canal présentant une forme en S ou en lacets, avec plusieurs parties parallèles les unes aux autres reliées par des parties coudées sensiblement de même largeur que les parties parallèles. L'ensemble du canal 24 est recouvert par une grille 21 constituée d'une couche mince électriquement isolante, par exemple en polysilicium, cette couche étant recouverte d'une métallisation constituant la connexion de grille. Les deux extrémités du canal comportent des contacts 23, 29 reliés à des métallisations respectives 22, 28 constituant respectivement les connexions de drain et de source du transistor. Le courant drain-source présente une composante aléatoire lorsque les dimensions du canal sont choisies proches du minimum de résolution offert par la technique de fabrication utilisée, voire légèrement inférieures à ce minimum, car l'on obtient alors des imperfections lors du développement du masque d'implantation du canal.

Ainsi, comme cela apparaît sur la vue agrandie de la figure 3a, lorsque le canal présente des dimensions et un pas de repliement des coudes proches de la limite offerte par technologie employée, voire légèrement inférieurs à cette limite, les parties coudées obtenues présentent une forme arrondie 24' à l'intérieur du coude.

Par exemple, avec une technologie d'intégration de 0,35 µm, la largeur des parties parallèles et coudées de la grille est inférieure à 1 µm, de préférence voisine de 0,7 µm, tandis que la distance entre les parties parallèles est de l'ordre de 1,5 µm.

Plus le nombre de coudes d'un tel transistor est élevé, plus la composante aléatoire ΔI du courant drain-source est importante. En contrepartie, le courant drain-source est plus faible et nécessite d'être amplifié avec un gain élevé. Il existe donc un nombre optimum de coudes qui dépend de l'échelle d'intégration du composant, par exemple 10 coudes dans un mode de réalisation testé par la demanderesse.

Le générateur 1 peut être couplé à un circuit logique 5 (figure 1) conçu pour générer à partir des trains de bits en sortie de la bascule 4, des nombres aléatoires d'une longueur en bits prédéfinie (par exemple 8, 16, 32 bits...). Ce circuit peut être un simple convertisseur série/parallèle ou être équipé de moyens permettant de combiner d'une manière plus complexe les bits du signal série appliqué en entrée. Ces moyens de combinaison peuvent par exemple être conçus pour corriger des éventuels défauts statistiques et améliorer le caractère aléatoire des nombres qui sont produits en sortie.

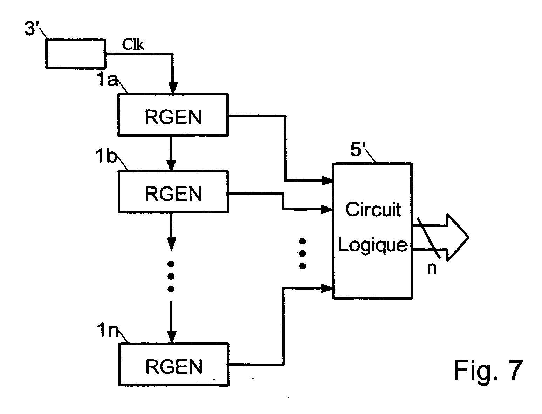

Alternativement, comme représenté sur la figure 7, plusieurs générateurs 1a, 1b,...1n selon l'invention peuvent être montés en parallèle, chaque générateur recevant un signal d'horloge Clk délivré par un oscillateur 3' commun. Un tel ensemble de générateurs délivre à chaque cycle d'horloge Clk un nombre aléatoire ayant une longueur n correspondant au nombre de générateurs montés en parallèle. Les sorties respectives des générateurs peuvent être combinées d'une manière simple ou complexe dans un circuit logique 5'.

Le générateur représenté sur la figure 1 ou 7 est tout à fait adapté pour être intégré dans un microcircuit tel que ceux qui équipent les cartes à puce, dont un exemple est représenté schématiquement en figure 6.

Le microcircuit 41 représenté comprend de façon classique une unité de traitement 42, par exemple un microprocesseur ou un microcontrôleur, des mémoires 44 de type ROM, RAM et/ou EEPROM, et un module de liaison 47 pour communiquer avec un terminal 51 externe, ces divers éléments étant interconnectés par un bus interne 43. Le microcircuit comprend également un générateur aléatoire 45 selon l'invention, incluant le générateur 1 précédemment décrit.

Le module de liaison 47, du type avec ou sans contact, est conçu pour coopérer avec un module de liaison 57 correspondant prévu dans un terminal 51, le terminal 51 comprenant lui-même une unité de traitement 52, des mémoires 54 et un bus interne 53 permettant à l'unité de traitement de communiquer avec les mémoires 54 et le module de liaison 57.

Le générateur aléatoire 45 intervient dans une procédure d'authentification du terminal 51 par le microcircuit 41, en vue d'autoriser une transaction.

A cet effet, l'unité de traitement 42 utilise le générateur 45 pour produire un nombre aléatoire "A" qui est transmis au terminal 51. Parallèlement, l'unité de traitement 42 calcule le résultat R = F_{KS}(A) de la transformation du nombre aléatoire "A" par une fonction d'authentification F_{KS} à clé secrète KS. Le terminal 51, qui connaît la clé secrète KS, effectue le même calcul et transmet au microcircuit 41 le résultat R' de la transformation. Si le microcircuit constate que les deux résultats R et R' sont identiques, il accepte de procéder à la transaction demandée par le terminal.

De préférence, le terminal 41 comprend également un générateur aléatoire 55 selon l'invention pour authentifier le microcircuit. Dans ce cas, le terminal exécute une procédure analogue à celle qui vient d'être décrite, en émettant un nombre aléatoire à destination du microcircuit, et en comparant le résultat calculé avec celui qui a été calculé et transmis par le microcircuit.

Il apparaîtra clairement à l'homme de l'art que le générateur aléatoire selon l'invention est susceptible de nombreux modes de réalisation, variantes et applications, tout en restant dans le cadre de l'enseignement qui précède.

## Revendications

1. Générateur de signal aléatoire du type utilisant une source de bruit électronique,
**caractérisé en ce que** la source de bruit électronique comprend un transistor MOS coudé (M_{C}), comportant un canal (24) en forme de S ou en lacets dont les dimensions sont à la limite de la résolution offerte par la technique de fabrication du transistor, le transistor présentant un courant drain-source ayant une composante aléatoire, le générateur comprenant des moyens pour produire un signal binaire aléatoire à partir de ladite composante aléatoire.

2. Générateur selon la revendication 1, comprenant un transistor de référence (M_{ref}) auquel est appliqué une tension de grille et un courant de polarisation, identiques à ceux appliqués au transistor coudé, pour extraire ladite composante aléatoire.

3. Générateur selon l'une des revendications 1 et 2, comprenant des moyens pour comparer ladite composante aléatoire à un courant de détection.

4. Générateur selon l'une des revendications 1 à 3, comprenant des moyens pour amplifier la composante aléatoire.

5. Générateur selon l'une des revendications 1 à 4, comprenant des moyens pour échantillonner (4) le signal binaire aléatoire, de manière à obtenir un signal numérique aléatoire.

6. Générateur selon la revendication 5, comprenant un circuit logique (5) pour produire des nombres binaires aléatoires à partir dudit signal numérique aléatoire.

7. Générateur selon l'une des revendications 1 à 6, comprenant des moyens pour maintenir automatiquement la tension de grille (V_{G}) du transistor coudé dans une plage de valeurs déterminée assurant la délivrance d'un signal de sortie équiprobable

8. Générateur selon l'une des revendications 1 à 7, comprenant plusieurs sources (1a, 1b,...1n) de bruit électronique produisant un courant ayant une composante aléatoire, chaque source étant couplée respectivement à des moyens pour générer un signal binaire aléatoire à partir de la composante aléatoire produite par la source, le générateur comprenant en outre des moyens (5) pour combiner les signaux binaires aléatoires issus des sources pour produire des nombres binaires aléatoires.

9. Circuit intégré, **caractérisé en ce qu'**il comprend un générateur (45, 55) de signal binaire aléatoire selon l'une des revendications 1 à 8, et des moyens (43, 53) pour relier la sortie du générateur à d'autres composants du circuit intégré.

10. Circuit intégré selon la revendication 9, agencé sur un support pour former une carte à puce ou tout autre objet électronique portable équivalent.

11. Circuit intégré selon la revendication 9 ou 10, comprenant une unité de traitement (42,52) comprenant des moyens pour recevoir un nombre aléatoire produit par le générateur, des moyens pour émettre (47,57) ce nombre aléatoire à destination d'un terminal extérieur, des moyens pour appliquer à ce nombre aléatoire une fonction d'authentification à clé secrète, des moyens pour comparer le résultat de cette fonction à un résultat fourni par le terminal en réponse à l'émission du nombre aléatoire, et des moyens pour autoriser une transaction avec le terminal si le résultat fourni par le terminal correspond au résultat calculé par l'unité de traitement.

12. Procédé pour générer un signal aléatoire à partir d'une source de bruit électronique, **caractérisé en ce qu'**il comprend les étapes consistant à :
- prévoir un transistor MOS coudé présentant un canal en forme de S ou en lacets dont les dimensions sont à la limite de la résolution offerte par la technique de fabrication du transistor,
- extraire une composante aléatoire de courant aux bornes d'un transistor MOS coudé,
- générer un signal binaire en fonction de la composante aléatoire, et
- échantillonner le signal binaire.

13. Procédé selon la revendication 12, comprenant des étapes consistant à amplifier la composante aléatoire et lui retrancher une valeur de référence avant de la convertir en un signal binaire.

14. Procédé selon l'une des revendications 12 et 13, comprenant une étape d'ajustement de la tension de grille du transistor coudé en fonction du signal binaire aléatoire obtenu à la suite de l'étape d'échantillonnage.

15. Procédé selon l'une des revendications 12 à 14, comprenant une étape consistant à générer des nombres binaires à partir dudit signal binaire.

## Claims

1. A random signal generator of the type using a source of electronic noise,
**characterized in that** the source of electronic noise comprises a bent MOS transistor (Mc), comprising an S-shaped or snaking channel (24) the dimensions of which are at the limit of the resolution provided by the transistor manufacturing technique, the transistor having a drain-source current with a random component, the generator comprising means for producing a random binary signal using said random component.

2. Generator according to claim 1, comprising a reference transistor (Mref) to which a gate voltage and a bias current identical to those applied to the bent transistor are applied, to extract said random component.

3. Generator according to one of claims 1 and 2, comprising means for comparing said random component with a detection current.

4. Generator according to one of claims 1 to 3, comprising means for amplifying the random component.

5. Generator according to one of claims 1 to 4, comprising means for sampling (4) the random binary signal, so as to obtain a random digital signal.

6. Generator according to claim 5, comprising a logic circuit (5) to produce random binary numbers using said random digital signal.

7. Generator according to one of claims 1 to 6, comprising means for automatically maintaining the gate voltage (V_{G}) of the bent transistor in a determined range of values ensuring the delivery of an equiprobable output signal.

8. Generator according to one of claims 1 to 7, comprising several sources (1a, 1b, ... 1n) of electronic noise producing a current having a random component, each source being respectively coupled to means for generating a random binary signal using the random component produced by the source, the generator further comprising means (5') for combining the random binary signals coming from the sources to produce random binary numbers.

9. An integrated circuit, **characterized in that** it comprises a random binary signal generator (45, 55) according to one of claims 1 to 8, and means (43, 53) for linking the output of the generator to other components of the integrated circuit.

10. Integrated circuit according to claim 9, arranged on a medium to form a smart card or any other equivalent portable electronic object.

11. Integrated circuit according to claim 9 or 10, comprising a processing unit (42, 52) comprising means for receiving a random number produced by the generator, means for sending (47, 57) this random number to an external terminal, means for applying a secret key authentication function to this random number, means for comparing the result of this function with a result supplied by the terminal in response to the sending of the random number, and means for authorizing a transaction with the terminal if the result supplied by the terminal corresponds to the result calculated by the processing unit.

12. A method for generating a random signal using a source of electronic noise, **characterized in that** it comprises the steps of:
- providing a bent MOS transistor having an S-shaped or snaking channel the dimensions of which are at the limit of the resolution provided by the transistor manufacturing technique,
- extracting a random current component at the terminals of a bent MOS transistor,
- generating a binary signal according to the random component, and
- sampling the binary signal.

13. Method according to claim 12, comprising steps of amplifying the random component and deducting a reference value from it before converting it into a binary signal.

14. Method according to one of claims 12 and 13, comprising a step of adjusting the gate voltage of the bent transistor according to the random binary signal obtained further to the sampling step.

15. Method according to one of claims 12 to 14, comprising a step of generating binary numbers using said binary signal.

## Patentansprüche

1. Zufallssignalgenerator des Typs, der eine Quelle elektronischen Rauschens verwendet,
**dadurch gekennzeichnet, dass** die Quelle elektronischen Rauschens einen gebogenen MOS-Transistor (Mc) umfasst, der einen Kanal (24) in Form eines S oder von Schleifen aufweist, dessen Abmessungen an der Grenze der Auflösung liegen, die das Herstellungsverfahren des Transistors zulässt, wobei der Transistor einen Drain-Source-Strom mit einer zufälligen Komponente aufweist, wobei der Generator Mittel umfasst, um ein binäres Zufallssignal auf der Grundlage der genannten Zufallskomponente zu erzeugen.

2. Generator nach Patentanspruch 1, einen Bezugstransistor (Mref) umfassend, an den eine Gitterspannung und ein Polarisationsstrom angelegt werden, die mit denen identisch sind, die an den gebogenen Transistor angelegt werden, um die genannte Zufallskomponente zu isolieren.

3. Generator nach irgendeinem der Patentansprüche 1 und 2, Mittel zum Vergleich der genannten Zufallskomponente mit einem Detektionsstrom umfassend.

4. Generator nach irgendeinem der Patentansprüche 1 bis 3, Mittel zur Verstärkung der Zufallskomponente umfassend.

5. Generator nach irgendeinem der Patentansprüche 1 bis 4, Mittel zur Abtastung (4) des binären Zufallssignals umfassend, um ein digitales Zufallssignal zu erhalten.

6. Generator nach Patentanspruch 5, einen logischen Schaltkreis (5) zur Erzeugung von binären Zufallszahlen auf der Grundlage des genannten digitalen Zufallssignals umfassend.

7. Generator nach irgendeinem der Patentansprüche 1 bis 6, Mittel umfassend, um die Gitterspannung (V_{G}) des gebogenen Transistors in einem bestimmten Wertebereich zu halten, der die Ausgabe eines gleich wahrscheinlichen Signals sicherstellt.

8. Generator nach irgendeinem der Patentansprüche 1 bis 7, mehrere Quellen elektronischen Rauschens (1a, 1b, ... 1n) umfassend, die einen Strom mit einer Zufallskomponente erzeugen, wobei jede Quelle jeweils an Mittel zur Erzeugung eines binären Zufallssignals auf der Grundlage der von der Quelle erzeugten Zufallskomponente angeschlossen ist, wobei der Generator außerdem Mittel (5) zur Kombination der binären Zufallssignale, die aus den Quellen stammen, zur Erzeugung binärer Zufallszahlen umfasst.

9. Integrierte Schaltung, **dadurch gekennzeichnet, dass** sie einen Generator (45, 55) eines binären Zufallssignals nach einem der Patentansprüche 1 bis 8 umfasst und Mittel (43, 53) zur Verbindung des Ausgangs des Generators mit anderen Komponenten der integrierten Schaltung.

10. Integrierte Schaltung nach Patentanspruch 9, auf einem Träger angeordnet, um eine Chipkarte oder ein beliebiges anderes äquivalentes, tragbares, elektronisches Objekt auszubilden.

11. Integrierte Schaltung nach Patentanspruch 9 oder 10, eine Datenverarbeitungseinheit (42, 52) umfassend, die Mittel zum Empfang einer vom Generator erzeugten Zufallszahl umfasst, Mittel zur Übermittlung (47, 57) dieser Zufallszahl an ein äußeres Terminal, Mittel zur Anwendung einer Authentifizierungsfunktion mit Geheimschlüssel auf diese Zufallszahl, Mittel zum Vergleich des Ergebnisses dieser Funktion mit einem Ergebnis, das das Terminal in Antwort auf die Übermittlung der Zufallszahl geliefert hat, und Mittel zur Zulassung einer Transaktion mit dem Terminal, wenn das vom Terminal gelieferte Ergebnis dem Ergebnis entspricht, das von der Datenverarbeitungseinheit berechnet wurde.

12. Verfahren zur Erzeugung eines Zufallssignals auf der Grundlage einer Quelle elektronischen Rauschens, **dadurch gekennzeichnet, dass** es die folgenden Schritte umfasst:
- Bereitstellung eines gebogenen MOS-Transistors, der einen Kanal in Form eines S oder von Schleifen aufweist, dessen Abmessungen an der Grenze der Auflösung liegen, die das Herstellungsverfahren des Transistors zulässt,
- Isolieren einer Zufallsstromkomponente an den Anschlüssen eines gebogenen MOS-Transistors,
- Erzeugung eines Binärsignals in Abhängigkeit von der Zufallskomponente, und
- Abtasten des Binärsignals.

13. Verfahren nach Patentanspruch 12, Schritte umfassend, die darin bestehen, die Zufallskomponente zu verstärken und um einen Bezugswert zu verringern, bevor sie in ein Binärsignal konvertiert wird.

14. Verfahren nach einem der Patentansprüche 12 und 13, einen Schritt der Einstellung der Gitterspannung des gebogenen Transistors in Abhängigkeit vom Zufallsbinärsignal, das nach dem Abtastschritt erhalten wurde, umfassend.

15. Verfahren nach einem der Patentansprüche 12 bis 14, einen Schritt der Erzeugung von Binärzahlen auf der Grundlage des genannten Binärsignals umfassend.
